# EUROPEAN PATENT APPLICATION

(11) **EP 2 629 336 A1**
(43) Date of publication of application: **21.08.2013**
(21) Application number: 11832421.9
(22) Date of filing: 30.09.2011
(51) Int. Cl.: H01L 31/042

(54) **SOLAR CELL MODULE**

(30) Priority: 27.01.2011 JP 2011015666; 14.10.2010 JP 2010231460
(71) Applicant: Hitachi Chemical Company, Ltd., Chiyoda-ku Tokyo 100-6606 (JP)
(72) Inventor: HAYASHI Hiroki, Tsukuba-shi Ibaraki 300-4247 (JP); KATOGI Shigeki, Tsukuba-shi Ibaraki 300-4247 (JP); SUKATA Shinichirou, Tsukuba-shi Ibaraki 300-4247 (JP); MOMOZAKI Aya, Tsukuba-shi Ibaraki 300-4247 (JP)
(74) Representative: Albrecht, Thomas
(86) International application number: PCT/JP2011/072658
(87) International publication number: WO 2012/049984

(57) **Abstract**

Provided is a solar cell module in which a plurality of solar cells and a wiring member for electrically connecting the solar cells are connected via connecting portions and, wherein a plurality of finger electrodes are formed on a light receiving surface of a photoelectric conversion body of the solar cell, the wiring member is arranged so as to intersect with the plurality of finger electrodes, and the connecting portion on a light receiving surface side comprises a metal portion which is formed by allowing conductive particles containing a metal having a melting temperature of 200°C or less to melt and aggregate in a resin and connects the individual finger electrodes and the wiring member; and a resin portion which is composed of the resin and surrounds the metal portion to bond the photoelectric conversion body and the wiring member.

## Description

### Technical Field

The present invention relates to a solar cell module.

### Background Art

As a means of solving serious problems of global warming and fossil energy depletion, solar cell modules which are power generation systems using solar light have been attracting attention. The current mainstream solar cell module has a structure in which solar cells comprising a single crystal or multi crystal Si wafer and electrodes formed on the wafer are connected to each other in series or parallel by a metal wiring member.

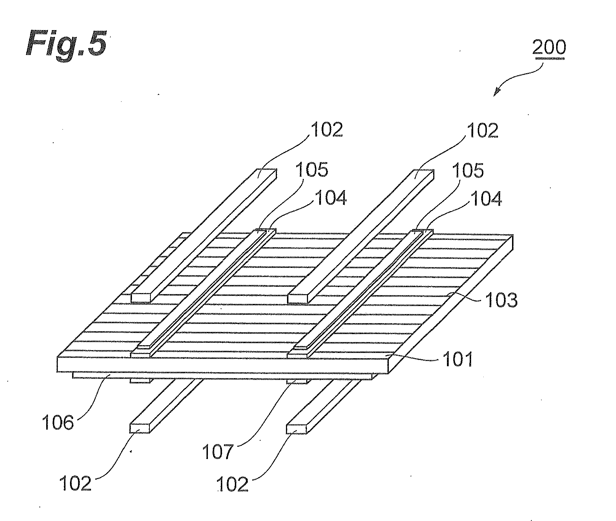

The configuration of a conventional solar cell module will be described with reference to Figure 5. Figure 5 is a schematic diagram for explaining a connection structure between electrodes and a wiring member in a conventional solar cell module. In a solar cell module 200 shown in Figure 5, finger electrodes 103 for collecting electricity generated in the inside of a photoelectric conversion body 101 of a single crystal or multi crystal solar cell are provided on a light receiving surface of the solar cell, and a busbar electrode 104 (hereinafter, also referred to as "front surface electrode") for taking the collected electricity to the outside is formed on the finger electrodes 103 so as to intersect with the finger electrodes 103 at a right angle. Moreover, rear surface electrodes 106 are provided on a rear surface side of the solar cell, and a busbar electrode 107 is formed on the rear surface electrodes 106 so as to intersect with the rear surface electrodes 106 at a right angle. Such solar cells are serially connected to each other through a wiring member 102. The wiring member 102 connects with the busbar electrode 104 on the front surface of the solar cell through a connecting portion 105 on the light receiving surface side at one end, and connects with the busbar electrode 107 on the rear surface through a connecting portion on the rear surface side (not shown) at another end.

Generally, for connection between the front surface electrode and the wiring member of the solar cell, solder, which has a satisfactory conductivity and is low in cost, has been used (Patent Literature 1). Recently, considering environmental problems, there have been known methods in which Sn-Ag-Cu solder not containing Pb is coated on a copper wire serving as the wiring member, and heating is performed at a temperature equal to or more than the melting temperature of the solder to connect the electrode and the wiring member of the solar cell (Patent Literatures 1 and 2).

On the other hand, for achieving reduction in cost, resource saving, and reduction in thickness of the solar cell module, there has been proposed a solar cell module without the front surface electrode (Patent Literature 3). Such solar cell module has a structure in which the finger electrode and the wiring member of the solar cell are directly connected, and a wiring member plated with solder of Sn, Sn-Ag-Cu, or the like is used for connection.

Furthermore, there has been proposed a solar cell module using a conductive adhesive which enables electrical connection by heating at a lower temperature (Patent Literature 4). The conductive adhesive is a composition in which metal particles, as typified by silver particles, are mixed and dispersed in a thermosetting resin, and electrical connection is achieved by the metal particles physically contacting the electrode and the wiring member of the solar cell.

### Citation List

### Patent Literature

[Patent Literature 1] Japanese Unexamined Patent Application Publication No. 2002-263880
[Patent Literature 2] Japanese Unexamined Patent Application Publication No. 2004-204256
[Patent Literature 3] Japanese Unexamined Patent Application Publication No. 2008-263163
[Patent Literature 4] Japanese Unexamined Patent Application Publication No. 2009-88152

### Summary of Invention

### Technical Problem

Here, for achieving reduction in cost, resource saving, and reduction in thickness of the solar cell module as described above, a solar cell module without a front surface electrode is desirable. Such solar cell module is more desirable when a solar cell has less danger of damage such as breakages or cracks and is excellent in connection properties between the wiring member and the electrode after a heat cycle test in which high temperature condition and low temperature condition are alternated repeatedly (hereinafter, referred to just as "connection properties").

Thus, an object of the present invention is to provide a solar cell module without a front surface electrode in which a solar cell has less danger of damage such as breakages or cracks and which exhibits satisfactory connection properties even after the heat cycle test.

### Solution to Problem

The present invention provides a solar cell module in which a plurality of solar cells and a wiring member for electrically connecting the solar cells are connected via a connecting portion, wherein a plurality of finger electrodes are formed on a light receiving surface of a photoelectric conversion body of the solar cell, the wiring member is arranged so as to intersect with the plurality of finger electrodes, and the connecting portion on a light receiving surface side comprises a metal portion which is formed by allowing conductive particles containing a metal having a melting temperature of 200°C or less to melt and aggregate in a resin and connects the individual finger electrodes and the wiring member; and a resin portion which is composed of the resin and surrounds the metal portion to bond the photoelectric conversion body and the wiring member.

According to the solar cell module, the solar cell has less danger of damage such as breakages or cracks and satisfactory connection properties are achieved even after the heat cycle test. Though the reason why such effects are exerted by the solar cell module of the present invention is not entirely clear, the present inventors think that one of the reasons is that resistance to heat strain in the heat cycle test is improved owing to the resin portion being present.

A width of the finger electrodes can be, for example, 20 to 400 µm.

The connecting portion can be formed by using a conductive adhesive composition comprising (A) conductive particles containing a metal having a melting temperature of 200°C or less (hereinafter, referred to just as "(A) conductive particles"), (B) a thermosetting resin, and (C) a flux activator.

It is noted that "melting temperature" means a temperature measured by, for example, differential scanning calorimetry (DSC) in the present description.

The present invention also provides a solar cell module in which a plurality of solar cells and a wiring member for electrically connecting the solar cells are connected via a connecting portion, wherein a plurality of finger electrodes are formed on a light receiving surface of a photoelectric conversion body of the solar cell, the wiring member is arranged so as to intersect with the plurality of finger electrodes, the connecting portion on a light receiving surface side comprises a metal portion which is formed by allowing conductive particles containing a metal having a melting temperature of 200°C or less to melt and aggregate in a resin and connects the individual finger electrodes and the wiring member; and a resin portion which is composed of the resin packed around the metal portion, and a cross section of the metal portion has a shape of spreading from a finger electrode side toward the wiring member. According to the solar cell module, the solar cell has less danger of damage such as breakages or cracks and satisfactory connection properties are achieved even after the heat cycle test.

### Advantageous Effects of Invention

According to the present invention, it is possible to provide a solar cell module in which a solar cell has less danger of damage such as breakages or cracks and which exhibits satisfactory connection properties even after a heat cycle test. Moreover, the solar cell module of the present invention can achieve reduction in cost, resource saving, and reduction in thickness because of not using a front surface electrode.

### Brief Description of Drawings

Figure 1 is a schematic diagram for explaining a connection structure between electrodes and a wiring member in a solar cell module according to the present embodiment.
Figure 2 is a schematic side view illustrating major components of the solar cell module according to the present embodiment.
Figure 3 is an enlarged schematic cross sectional view of a connecting portion on a light receiving surface side of the solar cell.
Figure 4 is an enlarged schematic cross sectional view illustrating a state in which the wiring member is provided on a conductive adhesive composition in the light receiving surface side.
Figure 5 is a schematic diagram for explaining a connection structure between electrodes and a wiring member in a conventional solar cell module.

### Description of Embodiments

Hereinafter, embodiments of the present invention will be described in detail, but it should be construed that the invention is in no way limited to those embodiments.

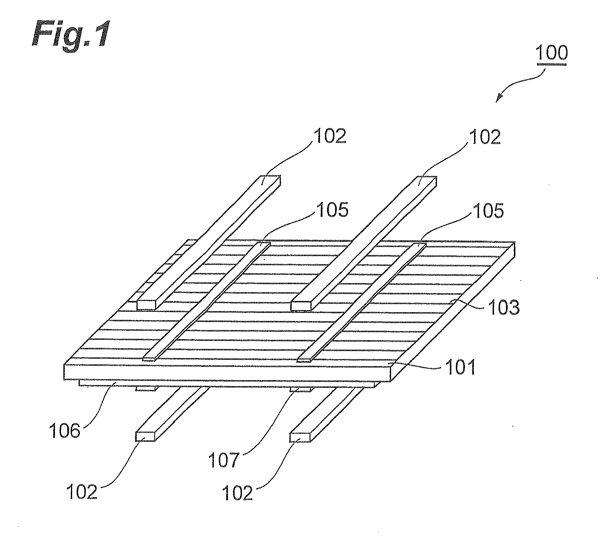

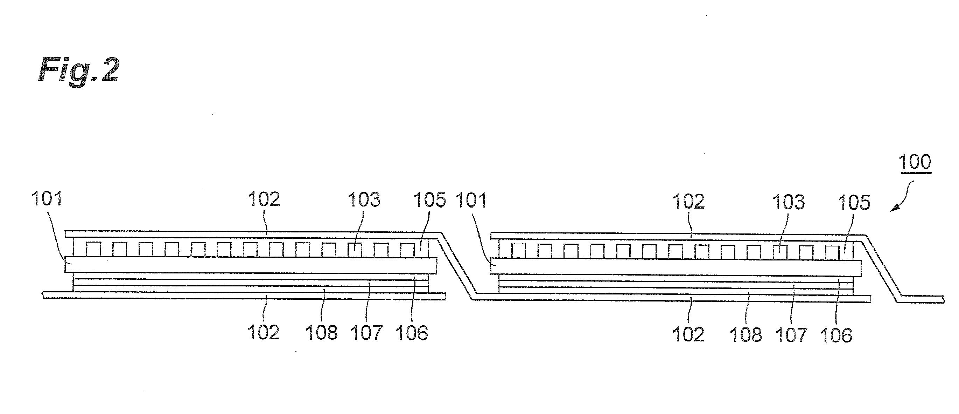

First, one embodiment of a solar cell module of the present invention will be described with reference to Figures 1 and 2. Figure 1 is a schematic diagram for explaining a connection structure between electrodes and a wiring member in a solar cell module according to the present embodiment. Figure 2 is a schematic side view illustrating major components of the solar cell module according to the present embodiment. In a solar cell module 100 of the present embodiment, finger electrodes 103 for collecting electricity generated in the inside of a photoelectric conversion body 101 of a single crystal or multi crystal solar cell are provided on a light receiving surface of the solar cell, rear surface electrodes 106 are provided on a rear surface side of the solar cell, and a busbar electrode 107 is formed on the rear surface electrodes 106 so as to intersect with the rear surface electrodes 106 at a right angle. Such solar cells are serially connected to each other via a wiring member 102. The wiring member 102 connects with the finger electrodes 103 on the front surface of the solar cell via a connecting portion 105 on the light receiving surface side at one end, and connects with the busbar electrode 107 on the rear surface via a connecting portion 108 on the rear surface side at another end. In the solar cell module 100 of the present embodiment, a front surface electrode as seen in the conventional solar cell module described above is not present.

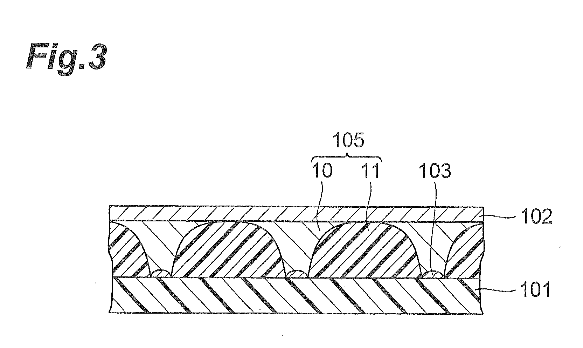

Figure 3 is an enlarged schematic cross sectional view of the connecting portion 105 on the light receiving surface side of the solar cell. The connecting portion 105 comprises a metal portion 10 which is formed by allowing conductive particles containing a metal having a melting temperature of 200°C or less to melt and aggregate in a resin; and a resin portion 11 which is composed of the resin packed around the metal portion 10. The finger electrodes 103 and the wiring member 102 are connected by the metal portion 10, and the metal portion 10 has a shape of spreading from a side of the finger electrodes 103 toward the wiring member 102. The photoelectric conversion body 101 and the wiring member 102 are bonded by the resin portion 11. The resin portion 11 more preferably comprises a cured material of a thermosetting resin. It is noted that the solar cell module of the present embodiment has only to comprise a metal portion which is formed by allowing conductive particles containing a metal having a melting temperature of 200°C or less to melt and aggregate and connects the finger electrodes on the front surface and the wiring member; and a resin portion which is composed of the resin and surrounds the metal portion to bond the photoelectric conversion body and the wiring member, and its shape is not limited to the one shown in Figure 3.

The solar cell module of the present embodiment is generally formed of several tens of units, regarding the connection structure described above as a repeating unit.

The electrode width of the finger electrodes 103 is preferably 20 to 400 µm, more preferably 50 to 200 µm. When the electrode width is less than 20 µm, reliability tends to decrease due to high electric resistance and breaking of the finger electrodes, and when the electrode width exceeds 400 µm, conversion efficiency tends to decrease due to the area of the photoelectric conversion body becoming narrow.

Moreover, the connecting portion 105 on the light receiving surface side has a ratio of the area of the metal portion to the area of the resin portion, [metal portion]/[resin portion], preferably of 5/95 to 80/20, more preferably of 20/80 to 70/30, in terms of the metal portion and the resin portion seen in a cross section cut along a median line of the wiring member in a longitudinal direction of the wiring member. When the ratio is less than 5/95, that is, the amount of the metal portion is small, the electric resistance tends to increase, and the ratio exceeds 80/20, that is, the amount of the metal portion is large, heat cycle resistance tends to decrease.

The solar cell module of the present embodiment can be produced by, for example, the following method.

First, a solar cell having finger electrodes with a width of 20 to 400 µm on a light receiving surface side is prepared. Next, a conductive adhesive composition described below is applied by using a dispenser in a direction perpendicular to the finger electrodes on the light receiving surface side. A conductive adhesive composition is similarly applied on rear surface electrodes provided on a rear surface side of the solar cell using a dispenser, but the order of application may be such that the application to the rear surface electrodes is conducted simultaneously with the application to the finger electrodes on the light receiving surface side, or the conductive adhesive composition is applied to the finger electrodes on the light receiving surface side, and then, applied to the rear surface electrodes after the solar cell is turned around. The application method of the conductive adhesive composition is not limited to the method using a dispenser described above, and a screen printing method or a transfer method may be employed. Further, the conductive adhesive composition may be applied not onto the electrodes but onto a wiring member.

Next, a wiring member is placed on the respective conductive adhesive compositions on the light receiving surface side and the rear surface side, and bonded by thermocompression using a thermocompression bonding machine. The temperature at the thermocompression bonding has only to be equal to or more than the melting temperature of a metal of (A) conductive particles described below, and is preferably 150 to 180°C. The pressure at the thermocompression bonding is preferably 0.01 to 1.0 MPa and the time for the thermocompression bonding can be 1 to 30 seconds. The step of thermocompression bonding between the wiring member and the electrodes of the solar cell is not conducted only by the method using a thermocompression bonding machine, and may be conducted by a method using hot air or a laminator. Similarly, in solar cells arranged in a plurality of numbers, wiring members are bonded by thermocompression by the same process as above, and thus, it is possible to produce a solar cell connecting structural body, that is, a connecting structural body in which the plurality of solar cells each having electrodes on both sides are electrically connected to each other by the wiring members. In the present embodiment, the connecting portion described above is formed by this connecting step.

After that, a sealing resin and a glass substrate are laminated on the light receiving surface side of the solar cell and the sealing resin and a protecting film called a back sheet are laminated on the rear surface side, and then, they are heated by a laminator at 150°C and a pressure of 0.1 MPa for 720 seconds, and as needed, the outer periphery is supported by an aluminum frame, and thereby a solar cell module can be produced.
It is noted that, in the production method described above, an example in which the connecting portions on the light receiving surface side and the rear surface side are both formed by using the conductive adhesive composition described below was explained; however, in the case of the connecting portion on the rear surface side, the conductive adhesive composition described below is not necessarily used and connection may be achieved by other known methods.

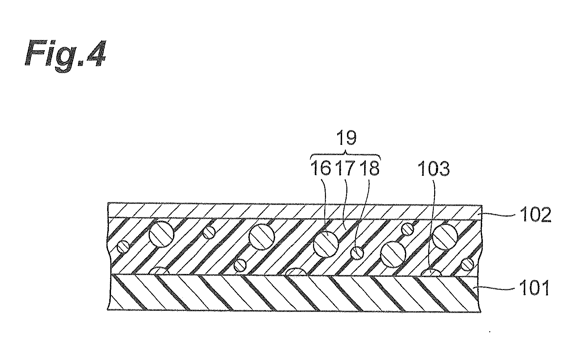

Figure 4 is an enlarged schematic cross sectional view illustrating a state in which the wiring member is provided on the conductive adhesive composition applied in a direction perpendicular to the finger electrodes on the light receiving surface side. A conductive adhesive composition 19 is provided between the photoelectric conversion body 101 having the finger electrodes 103 formed on the light receiving surface side and the wiring member 102. The conductive adhesive composition 19 comprises a resin 17, and conductive particles 16 and a flux activator 18 dispersed in the resin 17.

Though the reason why the connecting portion 105 as shown in Figure 3 is formed by heating the conductive adhesive composition 19 shown in Figure 4 under pressure is not entirely clear, the present inventors think that one of the reasons of the metal portion 10 having the shape described above is surface tension of the metal arising when a molten metal of the conductive particles contacts the finger electrodes 103.

An example of another method for producing the solar cell module of the present invention includes a method of conducting bonding of the electrodes and the wiring member of the solar cell and sealing of the solar cell at the same time.

The method of simultaneously conducting sealing of the solar cell is as follows. First, a plurality of solar cells in which the conductive adhesive composition described below is applied onto the finger electrodes on the light receiving surface side and the busbar electrode on the rear surface side are prepared. A wiring member is arranged so as to face the finger electrodes on the light receiving surface side of the solar cell at one end and is placed so as to face the busbar electrode on the rear surface side of another solar cell at another end, with the applied conductive adhesive composition intervening therebetween. Furthermore, a sealing resin is placed on the light receiving surface side of the solar cell, and a glass substrate is placed on the sealing resin. On the other hand, a sealing resin is placed on the rear surface side of the solar cell, and a protecting film is placed on the sealing resin. In this state, the whole is heated at a temperature at which the conductive particles in the conductive adhesive composition melt under pressure as needed, thereby the wiring member is electrically connected and bonded to the finger electrodes on the front surface and the busbar electrode on the rear surface side, and simultaneously, the solar cell is sealed with the sealing resin. In this case, the heating conditions are, for example, 150 to 180°C for 1 to 60 seconds. The pressure conditions are, for example, 0.01 to 1.0 MPa.

Examples of the wiring member include a Cu wire, a tab wire prepared by dipping or plating a Cu wire with solder, and a film-shaped wiring substrate having metal wiring formed on a plastic substrate. An example of the glass substrate includes a whiteboard reinforced glass with a dimple for a solar cell module. Examples of the sealing resin include a sealing resin utilizing an ethylene-vinyl acetate copolymer resin (EVA) or polyvinylbutyral. Examples of the protecting film include a PET type material, a tedlar (registered trademark)-PET laminated material, and a gold leaf-PET laminated material, and as a commercially available product thereof, a weather resistant film such as tedlar (vinyl fluoride resin) (registered trademark) manufactured by DuPont is used.

The conductive adhesive composition used for production of the solar cell module of the present embodiment preferably comprises (A) conductive particles, (B) a thermosetting resin, and (C) a flux activator.

As the (A) conductive particles, conductive particles containing a metal having a melting temperature of 200°C or less, preferably of 190°C or less can be used. When such conductive particles are used in the conductive adhesive composition, it is believed that the metal portion formed by allowing the metal to melt and aggregate can form a wide and strong conductive path, and therefore, it is possible to improve power generation efficiency because of lower resistance and improve resistance to heat strain in a heat cycle test in comparison with the case of a relatively thin and fragile path formed by contact between particles such as silver particles. The lower limit of the melting temperature of the metal in the (A) conductive particles is not particularly limited, but is generally about 120°C.

Considering environmental problems, it is preferred that the metal in the (A) conductive particles is composed of a metal other than lead. Examples of the metal constituting the (A) conductive particles include an elemental substance and an alloy comprising at least one component selected from tin (Sn), bismuth (Bi), indium (In), zinc (Zn), and the like. It is noted that the alloy can contain a component having a high melting temperature selected from Pt, Au, Ag, Cu, Ni, Pd, Al, and the like in the range in which the melting temperature of the metal as a whole in the (A) conductive particles is 200°C or less because more satisfactory connection reliability can be achieved.

As the metal constituting the (A) conductive particles, specifically, Sn42-Bi58 solder (melting temperature 138°C), Sn48-In52 solder (melting temperature 117°C), Sn42-Bi57-Ag1 solder (melting temperature 139°C), Sn90-Ag2-Cu0.5-Bi7.5 solder (melting temperature 189°C), Sn96-Zn8-Bi3 solder (melting temperature 190°C), Sn91-Zn9 solder (melting temperature 197°C), and the like are preferred because these solder show definite solidification behavior after melting. The solidification behavior means being solidified again by cooling down after melting. Among them, it is preferred to use Sn42-Bi58 solder because of its easy availability and lower melting temperature. These are used alone or in combination of two or more.

The average particle diameter of the (A) conductive particles is not particularly limited, but is preferably 0.1 to 100 µm. When the average particle diameter is less than 0.1 µm, the viscosity of the conductive adhesive composition tends to increase and workability tends to decrease. On the other hand, the average particle diameter of the conductive particles exceeds 100 µm, printing properties tend to decrease, and at the same time, the connection reliability tends to decrease. In view of further improving the printing properties and the workability of the conductive adhesive composition, the average particle diameter is more preferably 1.0 to 50 µm. Furthermore, in view of improving storage stability of the conductive adhesive composition and mounting reliability of the cured material, the average particle diameter is particularly preferably 5.0 to 30 µm. Here, the average particle diameter is a value obtained by a laser diffraction scattering method (test method No. 2 of Kamioka Mining & Smelting).

The (A) conductive particles may be conductive particles prepared by coating the surface of particles composed of a solid material other than a metal such as a ceramic, silica, and a resin material with a metal membrane composed of a metal having a melting temperature of 200°C or less as well as conductive particles composed only of a metal having a melting temperature of 200°C or less, or a mixture thereof.

It is preferred that the amount of the (A) conductive particles is such that the amount of the metal constituting the conductive particles is 5 to 95% by mass based on the total amount of the conductive adhesive composition. When the amount of the metal is less than 5% by mass, the conductivity of the cured material of the conductive adhesive composition tends to decrease. On the other hand, the amount of the metal exceeds 95% by mass, the viscosity of the conductive adhesive composition tends to increase and the workability tends to decrease. Moreover, the mounting reliability of the cured material tends to decrease because the amount of an adhesive component in the conductive adhesive composition is relatively reduced.

It is preferred that the amount of the metal constituting the (A) conductive particles is 30 to 95% by mass based on the total amount of the conductive adhesive composition. When the amount of the metal is less than 30% by mass, there is a tendency that the connection structure comprising the connecting portion described above is difficult to be formed and then securing conduction between the finger electrodes and the wiring member becomes difficult. On the other hand, when the amount of the metal exceeds 95% by mass, the viscosity of the conductive adhesive composition tends to increase and the workability tends to decrease. Moreover, the mounting reliability of the cured material tends to decrease because the amount of the adhesive component in the conductive adhesive composition is relatively reduced. Furthermore, the amount of the metal is more preferably 40 to 90% by mass in view of further improving the workability or the conductivity, further more preferably 50 to 85% by mass in view of further improving the mounting reliability of the cured material, and still more preferably 60 to 80% by mass in view of achieving a good balance between the heat cycle resistance and coating properties using a dispenser.

Bismuth, zinc, and the like which are examples of the metal having a melting temperature of 200°C or less are thought to be harder and more fragile in comparison with Sn-Ag-Cu solder used in the production of the conventional solar cell module. Therefore, when the finger electrodes and the wiring member of the solar cell are bonded just by melting the metal having a melting temperature of 200°C or less, the connection properties of the solar cell module cannot be maintained sufficiently after the heat cycle test. In the solar cell module of the present embodiment, the finger electrodes and the wiring member of the solar cell are electrically connected by the metal portion formed by allowing the (A) conductive particles to melt and aggregate, and besides, the photoelectric conversion body and the wiring member are bonded by the resin portion composed of the resin. Therefore, it is possible to resolve the brittleness common to the metals having a melting temperature of 200°C or less and improve the resistance to heat strain in the heat cycle test.

It is noted that conductive particles composed of a metal having a melting temperature higher than 200°C may be used in combination with the (A) conductive particles. Examples of such metal having a melting temperature higher than 200°C include a metal selected from Pt, Au, Ag, Cu, Ni, Pd, Al, and the like; and an alloy composed of two or more of the metals, and specific examples include an Au powder, an Ag powder, a Cu powder, and an Ag-plated Cu powder. As a commercially available product, "MA05K" which is a silver-plated copper powder (manufactured by Hitachi Chemical Co., Ltd., product name) is available.

Examples of the (B) thermosetting resin include a thermosetting organic high-molecular-weight compound such as an epoxy resin, a (meth)acrylic resin, a maleimide resin, and a cyanate resin; and precursors thereof. Here, the (meth)acrylic resin means a methacrylic resin and an acrylic resin. Among them, a compound having a polymerizable carbon-carbon double bond typified by the (meth)acrylic resin and the maleimide resin, or the epoxy resin is preferred. These (B) thermosetting resins are excellent in heat resistance and adhesion properties, and further, excellent in the workability because the (B) thermosetting resins can be handled in a liquid state when dissolved or dispersed in an organic solvent as needed. The (B) thermosetting resins described above are used alone or in combination of two or more.

The (meth)acrylic resin is composed of a compound having a polymerizable carbon-carbon double bond. Examples of such compound include a monoacrylate compound, a monomethacrylate compound, a diacrylate compound, and a dimethacrylate compound.

Examples of the monoacrylate compound include methyl acrylate, ethyl acrylate, propyl acrylate, isopropyl acrylate, n-butyl acrylate, isobutyl acrylate, t-butyl acrylate, amyl acrylate, isoamyl acrylate, hexyl acrylate, heptyl acrylate, octyl acrylate, 2-ethyl hexyl acrylate, nonyl acrylate, decyl acrylate, isodecyl acrylate, lauryl acrylate, tridecyl acrylate, hexadecyl acrylate, stearyl acrylate, isostearyl acrylate, cyclohexyl acrylate, isobomyl acrylate, diethylene glycol acrylate, polyethylene glycol acrylate, polypropylene glycol acrylate, 2-methoxyethyl acrylate, 2-ethoxyethyl acrylate, 2-butoxyethyl acrylate, methoxydiethylene glycol acrylate, methoxypolyethylene glycol acrylate, dicyclopentenyl oxyethyl acrylate, 2-phenoxyethyl acrylate, phenoxydiethylene glycol acrylate, phenoxypolyethylene glycol acrylate, 2-benzoyl oxyethyl acrylate, 2-hydroxy-3-phenoxypropyl acrylate, benzyl acrylate, 2-cyanoethyl acrylate, γ-acryloxyethyl trimethoxysilane, glycidyl acrylate, tetrahydrofurfuryl acrylate, dimethyl aminoethyl acrylate, diethyl aminoethyl acrylate, acryloxyethyl phosphate and acryloxyethyl phenyl acid phosphate.

Examples of the monomethacrylate compound include methyl methacrylate, ethyl methacrylate, propyl methacrylate, isopropyl methacrylate, n-butyl methacrylate, isobutyl methacrylate, t-butyl methacrylate, amyl methacrylate, isoamyl methacrylate, hexyl methacrylate, heptyl methacrylate, octyl methacrylate, 2-ethyl hexyl methacrylate, nonyl methacrylate, decyl methacrylate, isodecyl methacrylate, lauryl methacrylate, tridecyl methacrylate, hexadecyl methacrylate, stearyl methacrylate, isostearyl methacrylate, cyclohexyl methacrylate, isobornyl methacrylate, diethylene glycol methacrylate, polyethylene glycol methacrylate, polypropylene glycol methacrylate, 2-methoxyethyl methacrylate, 2-ethoxyethyl methacrylate, 2-butoxyethyl methacrylate, methoxydiethylene glycol methacrylate, methoxypolyethylene glycol methacrylate, dicyclopentenyl oxyethyl methacrylate, 2-phenoxyethyl methacrylate, phenoxydiethylene glycol methacrylate, phenoxypolyethylene glycol methacrylate, 2-benzoyloxyethyl methacrylate, 2-hydroxy-3-phenoxypropyl methacrylate, benzyl methacrylate, 2-cyanoethyl methacrylate, γ-methacryloxyethyl trimethoxysilane, glycidyl methacrylate, tetrahydrofurfuryl methacrylate, dimethylaminoethyl methacrylate, diethylaminoethyl methacrylate, methacryloxyethyl phosphate and methacryloxyethyl phenyl acid phosphate.

Examples of the diacrylate compound include ethylene glycol diacrylate, 1,4-butanediol diacrylate, 1,6-hexanediol diacrylate, 1,9-nonanediol diacrylate, 1,3-butanediol diacrylate, neopentyl glycol diacrylate, diethylene glycol diacrylate, triethylene glycol diacrylate, tetraethylene glycol diacrylate, polyethylene glycol diacrylate, tripropylene glycol diacrylate, polypropylene glycol diacrylate; a reaction product between 1 mole of bisphenol A, bisphenol F or bisphenol AD and 2 moles of glycidyl acrylate; diacrylate of a polyethylene oxide adduct of bisphenol A, bisphenol F, or bisphenol AD; diacrylate of a polypropylene oxide adduct of bisphenol A, bisphenol F, or bisphenol AD; and a bis(acryloxypropyl)polydimethylsiloxane and bis(acryloxypropyl)methylsiloxane-dimethylsiloxane copolymer.

Examples of the dimethacrylate compound include ethylene glycol dimethacrylate, 1,4-butanediol dimethacrylate, 1,6-hexanediol dimethacrylate, 1,9-nonanediol dimethacrylate, 1,3-butanediol dimethacrylate, neopentyl glycol dimethacrylate, diethylene glycol dimethacrylate, triethylene glycol dimethacrylate, tetraethylene glycol dimethacrylate, polyethylene glycol dimethacrylate, tripropylene glycol dimethacrylate, polypropylene glycol dimethacrylate; a reaction product between 1 mole of bisphenol A, bisphenol F or bisphenol AD and 2 moles of glycidyl methacrylate; dimethacrylate of a polyethylene oxide adduct of bisphenol A, bisphenol F, or bisphenol AD; a polypropylene oxide adduct of bisphenol F or bisphenol AD; and a bis(methacryloxypropyl)polydimethylsiloxane and bis(methacryloxypropyl)methylsiloxane-dimethylsiloxane copolymer.

These compounds are used alone or in combination of two or more. Moreover, when the (meth)acrylic resin is used as the thermosetting resin, these compounds may be used after preliminarily polymerized, or may be mixed with the (A) conductive particles and the (C) flux activator, and then, subjected to mixing and polymerization at the same time.

When the (B) thermosetting resin is composed of a compound having a polymerizable carbon-carbon double bond, it is preferred that the conductive adhesive composition comprises a radical polymerization initiator. As the radical polymerization initiator, an organic peroxide is preferred in view of effectively suppressing voids. Furthermore, in view of improving curability and viscosity stability of the conductive adhesive composition, the organic peroxide has a decomposition temperature preferably of 70 to 170°C, more preferably of 80 to 160°C.

Examples of the radical polymerization initiator include 1,1,3,3,-tetramethyl butyl peroxy 2-ethyl hexanoate, 1,1-bis(t-butyl peroxy)cyclohexane, 1,1-bis(t-butyl peroxy)cyclododecane, di-t-butyl peroxyisophthalate, t-butyl peroxybenzoate, dicumyl peroxide, t-butyl cumyl peroxide, 2,5-dimethyl-2,5-di(t-butyl peroxy)hexane, 2,5-dimethyl-2,5-di(t-butyl peroxy)-3-hexyne and cumene hydroperoxide. These are used alone or in combination of two or more.

The amount of the radical polymerization initiator is preferably 0.01 to 20% by mass, more preferably 0.1 to 10% by mass, still more preferably 0.5 to 5% by mass based on the total amount of components of the conductive adhesive composition except for the conductive particles (hereinafter, referred to as "adhesive component").

As the acrylic resin, commercially available ones can be used. Specific examples thereof include FINEDIC A-261 (manufactured by Dainippon Ink and Chemicals, product name) and FINEDIC A-229-30 (manufactured by Dainippon Ink and Chemicals, product name).

As the epoxy resin, known compounds can be used without any limitation as long as the compound contains two or more epoxy groups in one molecule. Examples of such epoxy resin include an epoxy resin derived from bisphenol A, bisphenol F, bisphenol AD, or the like and epichlorohydrin.

As the epoxy resin, commercially available ones can be used. Specific examples thereof include AER-X8501 (manufactured by Asahi Chemical Industry Co., Ltd., product name) which is a bisphenol A type epoxy resin; R-301 (manufactured by Japan epoxy resins Co., Ltd., product name); YL-980 (manufactured by Japan epoxy resins Co., Ltd., product name); YDF-170 (manufactured by Tohto Kasei Co., Ltd., product name) which is a bisphenol F type epoxy resin; YL-983 (manufactured by Japan epoxy resins Co., Ltd., product name); R-1710 (manufactured by Mitsui Petrochemical Industries, product name) which is a bisphenol AD type epoxy resin; N-730S (manufactured by Dainippon Ink and Chemicals, product name) which is a phenol novolac type epoxy resin; Quatrex-2010 (manufactured by The Dow Chemical Company, product name); YDCN-702S (manufactured by Tohto Kasei Co., Ltd., product name) which is a cresol novolac type epoxy resin; EOCN-100 (manufactured by Nippon Kayaku Co., Ltd., product name); EPPN-501 (manufactured by Nippon Kayaku Co., Ltd., product name) which is a multifunctional epoxy resin; TACTIX-742 (manufactured by The Dow Chemical Company, product name); VG-3010 (manufactured by Mitsui Petrochemical Industries, product name); 1032S (manufactured by Japan epoxy resins Co., Ltd., product name); HP-4032 (manufactured by Dainippon Ink and Chemicals, product name) which is an epoxy resin having a naphthalene skeleton; EHPE-3150 and CEL-3000 (both manufactured by Daicel Chemical Industries, Ltd., product name) which are alicyclic epoxy resins; DME-100 (manufactured by New Japan Chemical Co., Ltd., product name); EX-216L (manufactured by Nagase ChemteX Corporation, product name); W-100 (manufactured by New Japan Chemical Co., Ltd., product name) which is an aliphatic epoxy resin; ELM-100 (manufactured by Sumitomo Chemical Co., Ltd., product name) which is an amine type epoxy compound; YH-434L (manufactured by Tohto Kasei Co., Ltd., product name); TETRAD-X and TETRAD-C (both manufactured by MITSUBISHI GAS CHEMICAL COMPANY, INC., product name); 630 and 630LSD (both manufactured by Japan epoxy resins Co., Ltd., product name); Denacol EX-201 (manufactured by Nagase Chemicals, Ltd., product name) which is a resorcin type epoxy resin; Denacol EX-211 (manufactured by Nagase ChemteX Corporation, product name) which is a neopentyl glycol type epoxy resin; Denacol EX-212 (manufactured by Nagase ChemteX Corporation, product name) which is a hexanedienyl glycol type epoxy resin; Denacol EX series (EX-810, 811, 850, 851, 821, 830, 832, 841, and 861 (all manufactured by Nagase ChemteX Corporation, product name)) which are ethylene-propylene glycol type epoxy resins; and epoxy resins E-XL-24 and E-XL-3L represented by the following formula (I) (both manufactured by Mitsui Chemicals, Inc., product name). Among these epoxy resins, the bisphenol A type epoxy resin, the bisphenol F type epoxy resin, the bisphenol AD type epoxy resin, and the amine type epoxy resin are particularly preferred because such epoxy resins contain lower amounts of ionic impurities and are excellent in reactivity. 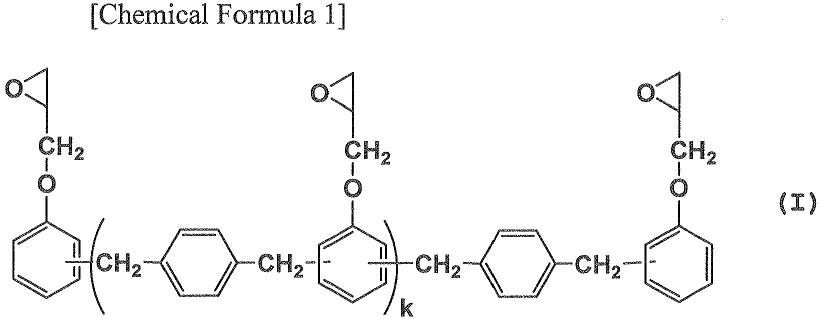 Here, in the formula (I), k represents an integer from 1 to 5.

The epoxy resins described above are used alone or in combination of two or more.

When the conductive adhesive composition comprises the epoxy resin as the (B) thermosetting resin, the conductive adhesive composition may further comprise an epoxy compound having only one epoxy group in one molecule as a reactive diluent. Such epoxy compound can be used as commercially available products. Specific examples thereof include PGE (manufactured by Nippon Kayaku Co., Ltd., product name); PP-101 (manufactured by Tohto Kasei Co., Ltd., product name); ED-502, ED-509, and ED-509S (manufactured by Asahi Denka Co., Ltd., product name); YED-122 (manufactured by Yuka Shell Epoxy KK, product name); KBM-403 (manufactured by Shin-Etsu Chemical Co., Ltd., product name); and TSL-8350, TSL-8355, and TSL-9905 (manufactured by TOSHIBA SILICONE, product name). These are used alone or in combination of two or more.

The amount of the reactive diluent may be in the range that does not block the effect of the present invention, and is preferably 0 to 30% by mass based on the total amount of the epoxy resin described above.

When the conductive adhesive composition comprises the epoxy resin as the (B) thermosetting resin, it is more preferred that the conductive adhesive composition comprises a curing agent or a curing accelerator.

As the curing agent, conventionally used ones can be used without any limitation, and commercially available ones can be used. Examples of the commercially available curing agent include H-1 (manufactured by Meiwa Plastic Industries, Ltd., product name) which is a phenol novolac resin; VR-9300 (manufactured by Mitsui Toatsu Chemicals, product name); XL-225 (manufactured by Mitsui Toatsu Chemicals, product name) which is a phenolaralkyl resin; MTPC (manufactured by Honshu Chemical Industry Co., Ltd., product name) which is a p-cresol novolac resin represented by the following formula (II); AL-VR-9300 (manufactured by Mitsui Toatsu Chemicals, product name) which is an allylated phenol novolac resin; and PP-700-300 (manufactured by Nippon Petrochemicals Co., Ltd., product name) which is a special phenol resin represented by the following formula (III).

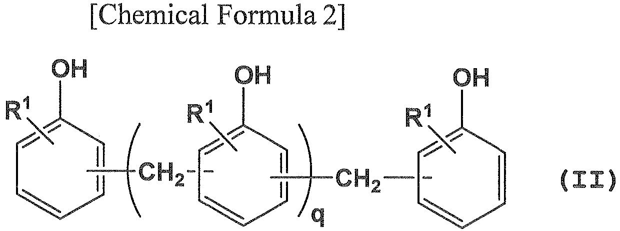

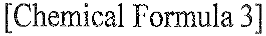

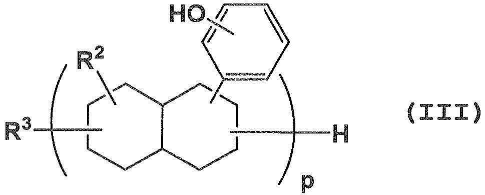

In the formula (II), R¹ each independently represents a monovalent hydrocarbon group, preferably a methyl group or an allyl group, and q represents an integer from 1 to 5. In the formula (III), R² represents an alkyl group, preferably a methyl group or an ethyl group, R³ represents a hydrogen atom or a monovalent hydrocarbon group, and p represents an integer from 2 to 4.

The amount of the curing agent is such that the total amount of a reaction active group in the curing agent is preferably 0.2 to 1.2 equivalents, more preferably 0.4 to 1.0 equivalents, still more preferably 0.5 to 1.0 equivalents, based on 1.0 equivalent of the epoxy group in the epoxy resin. When the amount of the reaction active group is less than 0.2 equivalents, reflow cracking resistance of the conductive adhesive composition tends to decrease, and when the amount of the reaction active group exceeds 1.2 equivalents, the viscosity of the conductive adhesive composition tends to increase and the workability tends to decrease. The reaction active group described above means a substituent group having reaction activity with the epoxy resin, and an example thereof includes a phenolic hydroxyl group.

As the curing accelerator, those conventionally used as a curing accelerator, such as dicyandiamide, can be used without any limitation, and commercially available products can be used. Examples of the commercially available product include ADH, PDH, and SDH (all manufactured by JAPAN HYDRAZINE COMPANY, INC., product name) which are dibasic acid dihydrazide represented by the following formula (IV); and Novacure (manufactured by Asahi Chemical Industry Co., Ltd., product name) which is a microcapsule type curing agent composed of a reaction product between an epoxy resin and an amine compound. These curing accelerators are used alone or in combination of two or more. 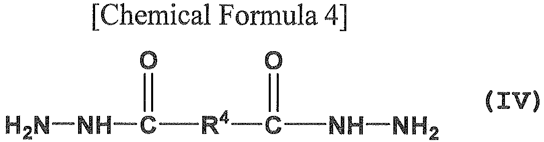 In formula (IV), R⁴ represents a divalent aromatic group or a linear or branched alkylene group having 1 to 12 carbon atoms, preferably m-phenylene group or p-phenylene group.

The amount of the curing accelerator is preferably 0.01 to 90 parts by mass, more preferably 0.1 to 50 parts by mass based on 100 parts by mass of the epoxy resin. When the amount of the curing accelerator is less than 0.01 parts by mass, the curability tends to decrease, and when the amount of the curing accelerator exceeds 90 parts by mass, the viscosity tends to increase, and the workability in the handling of the conductive adhesive composition tends to decrease.

As the commercially available curing accelerator, EMZ-K and TPPK (both manufactured by HOKKO CHEMICAL INDUSTRY CO., LTD., product name) which are organoboron compounds; DBU, U-CAT102, 106, 830, 840, and 5002 (all manufactured by San-Apro Ltd., product name) which are tertiary amines or salts thereof; CUREZOL 2PZ-CN, 2P4MHZ, C17Z, 2PZ-OK, 2PZ-CNS, and C11Z-CNS (all manufactured by SHIKOKU CHEMICALS CORPORATION, product name) which are imidazoles, and the like may be used in addition to or instead of the products described above.

The amount of the curing accelerator just described is preferably 20 parts by mass or less based on 100 parts by mass of the epoxy resin. The amount of the curing accelerator is more preferably 15 parts by mass or less.

The curing agents and the curing accelerators are each used alone or in combination of two or more.

It is noted that, in the conductive adhesive composition, one type or two or more types of a thermoplastic resin serving as a binder may be added in addition to the (B) thermosetting resin described above. Examples of the thermoplastic resin include a polyimide resin, a polyamide resin, a polyether resin, a polyurethane resin, a polyacrylate, and a phenoxy resin as a homopolymer or a copolymer of two or more of the thermoplastic resins described above. These thermoplastic resins are used alone or in combination of two or more.

The amount of the (B) thermosetting resin in the conductive adhesive composition is preferably 1 to 60% by mass, more preferably 5 to 40% by mass, still more preferably 10 to 30% by mass based on the total amount of the adhesive component.

The (C) flux activator is a compound having a function of removing oxidized membranes formed on the surface of the (A) conductive particles. As the flux activator, known compounds can be used without any limitation as long as the compound does not interfere with the curing reaction of the (B) thermosetting resin. Examples of such compound include a rosin type resin, a compound having a carboxyl group, a phenolic hydroxyl group, or an alcoholic hydroxyl group in the molecule, an dibasic acid having an alkyl group in a side chain such as 2,4-diethylglutaric acid, 2,2-diethylglutaric acid, 3-methylglutaric acid, 2-ethyl-3-propylglutaric acid, and 2,5-diethyladipic acid. A compound having a carboxyl group and a hydroxyl group is preferred, and particularly, an aliphatic dihydroxy carboxylic acid is preferred because such compound exhibits satisfactory flux activity and has satisfactory reactivity with the epoxy resin used as the (B) thermosetting resin. Specifically, a compound represented by the following formula (V) or tartaric acid is preferred.

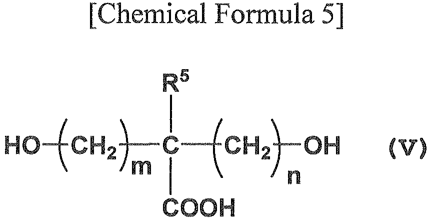

Here, in formula (V), R⁵ represents a substituted or unsubstituted alkyl group having 1 to 5 carbon atoms. In view of exerting the effect of using the compound represented by formula (V) more effectively, it is preferred that R⁵ is a methyl group, an ethyl group, or a propyl group. Moreover, n and m each independently represent an integer from 0 to 5. In view of exerting the effect of using the compound represented by formula (V) more effectively, it is preferred that n is 0 and m is 1 or both of n and m are 1, and it is more preferred that both of n and m are 1.

Examples of the compound represented by formula (V) include 2,2-bis(hydroxymethyl)propionic acid, 2,2-bis(hydroxymethyl)butanoic acid, and 2,2-bis(hydroxymethyl)pentanoic acid.

In view of exerting the effect of the present invention described above more effectively, the amount of the (C) flux activator is preferably 0.5 to 20 parts by mass based on 100 parts by mass of the total amount of the metal having a melting temperature of 200°C or less. Furthermore, in view of the storage stability and conductivity, the amount of the (C) flux activator is more preferably 1.0 to 10 parts by mass. When the amount of the (C) flux activator is less than 0.5 parts by mass, meltability of the metal in the (A) conductive particles tends to decrease and the conductivity tends to decrease, and when the amount of the (C) flux activator exceeds 20 parts by mass, the storage stability, the printing properties, and the coating properties using a dispenser tend to decrease.

In addition to the components described above, the conductive adhesive composition may comprise one or more additives selected from the group consisting of a flexibility imparting agent for stress relaxation, a diluent for improving workability, an adhesion improving agent, a wettability improving agent, and an antifoaming agent, as needed. Moreover, in addition to these components, various additives may be contained in the range that does not block the effect of the present invention.

An example of the flexibility imparting agent includes liquefied polybutadiene (product name "CTBN-1300X31" and "CTBN-1300X9" manufactured by UBE INDUSTRIES, LTD.; and product name "NISSO-PB-C-2000" manufactured by Nippon Soda Co., Ltd.). When the flexibility imparting agent is contained, it is generally preferred that the amount of the flexibility imparting agent is 0.01 to 500 parts by mass based on 100 parts by mass of the total amount of the thermosetting resin.

For the purpose of improving the adhesion, the conductive adhesive composition may contain a coupling agent such as a silane coupling agent and a titanium coupling agent. An example of the silane coupling agent includes product name "KBM-573" manufactured by Shin-Etsu Chemical Co., Ltd. Moreover, for the purpose of improving the wettability, an anionic surfactant, a fluorosurfactant, or the like may be contained in the conductive adhesive composition. Furthermore, the conductive adhesive composition may contain a silicone oil or the like as the antifoaming agent, or may contain an aliphatic ester such as castor wax obtained by hydrogenating a castor oil as a thixotropic agent. The adhesion improving agents, the wettability improving agents, and the antifoaming agents described above are each used alone or in combination of two or more. It is preferred that these additives are contained in an amount of 0.1 to 10% by mass based on the total amount of the conductive adhesive composition.

For enhancing the workability in the production of the conductive adhesive composition and coating workability at the time of its use, a diluent can be contained in the conductive adhesive composition as needed. Preferred examples of such diluent include an organic solvent having a relatively high boiling temperature such as butyl cellosolve, carbitol, butyl cellosolve acetate, carbitol acetate, dipropylene glycol monomethyl ether, ethylene glycol diethyl ether, and α-terpineol. It is preferred that the diluent is contained in an amount of 0.1 to 30% by mass based on the total amount of the conductive adhesive composition.

The conductive adhesive composition may contain a filler. Examples of the filler include polymer particles such as acrylic rubber and polystyrene; and inorganic particles such as diamond, boron nitride, aluminum nitride, alumina, and silica. These fillers are used alone or as a mixture of two or more.

In the present embodiment, any of the exemplified components described above may be used in combination.

The components described above are subjected to mixing, dissolution, decoagulation kneading or dispersion, with heating as needed at one time or in a plurality of installments, and then, the conductive adhesive composition of the present embodiment is obtained as a paste in which the components are dispersed uniformly. Examples of a dispersing/dissolving apparatus used here include known stirrers, kneaders, triple rolls, and planetary mixers.

In view of the printing properties and the coating properties using a dispenser, the conductive adhesive composition is preferably a liquid one.

The solar cell module of the present embodiment can be produced by connection at a low temperature of 200°C or less by means of using the conductive adhesive composition described above, and therefore, it is possible to suppress deterioration in the properties of the solar cell and decrease in the yield caused by warpages or cracks of the solar cell in comparison with the conventional solar cell module produced by connection at 260°C or more using Sn-Ag-Cu solder.

### Examples

Hereinafter, the present invention will be further described with Examples, but it should be construed that the invention is in no way limited to those Examples.

### (Example 1)

### [Preparation of conductive adhesive composition]

26.7 parts by mass of YDF-170 (manufactured by Tohto Kasei Co., Ltd., product name of a bisphenol F type epoxy resin, epoxy equivalent = 170) serving as (B) a thermosetting resin, 1.2 parts by mass of 2P4MZ (manufactured by SHIKOKU CHEMICALS CORPORATION, product name of 2-phenyl-4-methylimidazole) serving as its curing accelerator, and 2.1 parts by mass of BHPA (2,2-bis(hydroxymethyl)propionic acid) serving as (C) a flux activator were mixed, and passed through a triple roll three times, thus preparing an adhesive component.

Next, 70 parts by mass of Sn42-Bi58 particles (average particle diameter 20 µm, melting temperature: 138°C) serving as (A) conductive particles was added to and mixed with 30 parts by mass of the adhesive component described above. The resultant mixture was passed through a triple roll three times, and then, subjected to a defoaming treatment at 500 Pa or less for 10 minutes by using a vacuum mixing and kneading machine, and thus, a conductive adhesive composition was obtained.

### [Production of solar cell with tab wire]

The liquid conductive adhesive composition obtained above was applied in a direction perpendicular to front surface finger electrodes (material: silver glass paste, 0.15 mm × 125 mm) formed on a light receiving surface of a solar cell (125 mm × 125 mm, thickness 310 µm) and at the right back position of rear surface electrodes so that the amount of the composition was 0.2 mg/mm in terms of the weight per unit length by using a dispenser. Next, a tab wire coated with solder (manufactured by Hitachi Cable, Ltd., product name: A-TPS, a product of width 0.5 mm) was arranged on the finger electrodes having the conductive adhesive composition applied thereon as a wiring member, and then, bonded by thermocompression using a thermocompression bonding machine under conditions of a temperature of 150°C, a load of 0.5 MPa, and a holding time of 10 seconds. The same treatment was conducted on the electrodes on the rear surface of the solar cell, and 10 sets of the solar cells with tab wire were produced.

### [Evaluation of cell damage rate]

The exterior appearance of the solar cells with tab wire was visually observed, and presence or absence of breakages and cracks was confirmed. The damage rate was evaluated and the result is shown in Table 1. In Table 1, the denominator in the cell damage rate represents the number of the evaluated solar cells, and the numerator represents the number of the solar cells in which damage such as breakages or cracks was confirmed.

### [Confirmation of connecting portion]

An epoxy resin was casted so as to cover the whole of 1 set of the solar cell with tab wire obtained above, and a cross section of a connecting portion when cut along a median line of the tab wire in a longitudinal direction of the tab wire was confirmed. The cross section was confirmed at 5 points, regarding an area from the center of the cross section of one finger electrode to the center of the cross section of the adjacent finger electrode as one observation unit. When the finger electrodes of the solar cell and the tab wire are connected by a molten material of the conductive particles, an area ratio between a metal portion contacting the finger electrode in the connecting portion and a resin portion contacting a photoelectric conversion body in the connecting portion was measured.

### [Production of solar cell module]

The solar cell with tab wire produced above was prepared, and a sealing resin (manufactured by MITSUI CHEMICALS FABRO INC, product name: Solar Ever SC50B) and a protecting film (manufactured by KOBAYASHI & CO., LTD., product name: koba tech PV) were laminated on the rear surface side of the solar cell, and a sealing resin (manufactured by MITSUI CHEMICALS FABRO INC, Solar Ever SC50B) and a glass (200 × 200 × 3 mm) were laminated on the light receiving surface side of the solar cell. The laminated body thus obtained was provided in a vacuum laminator (manufactured by NPC Incorporated, product name: LM-50X50-S) so that the glass contacted a hot plate side, and vacuuming was performed for 5 minutes, and then, vacuum at the upper portion of the vacuum laminator was released and heating was performed at 160°C and a pressure of 1 atm for 10 minutes, thus producing a solar cell module.

### [Conversion efficiency and FF measurement, heat cycle test]

An I-V curve of the obtained solar cell module was measured by using a solar simulator (manufactured by WACOM ELECTRIC CO., LTD., product name: WXS-155S-10, AM: 1.5G), and a fill factor (hereinafter, abbreviated to as F.F) was obtained, which was taken as an initial F.F (0 h). Moreover, at this time, the conversion efficiency was also obtained. Next, a heat cycle test in which a cycle of -55°C for 15 minutes and 125°C for 15 minutes was repeated 1000 times was performed on the solar cell module. The F.F of the solar cell module after the heat cycle test was measured, which was taken as F.F (1000 h). A rate of F.F change before and after the heat cycle test (ΔF.F) was obtained by the formula [F.F (1000 h) × 100/F.F (0 h)], and this was used as an evaluation indicator. It is noted that, generally, ΔF.F value of 95% or more is evaluated as having satisfactory connection reliability.

### (Examples 2 to 9)

Conductive adhesive compositions were prepared by the same process as that in Example 1 except that the compositions were those shown in Table 1. Then, solar cells with tab wire were produced by the same process as that in Example 1 except that the obtained conductive adhesive compositions were used, and evaluation of cell damage rate and confirmation of connecting portion were conducted. It is noted that, in Example 7, the thermocompression temperature between the finger electrodes and the wiring member was 170°C.

Moreover, solar cell modules were produced by the same process as that in Example 1 except that the obtained solar cells with tab wire were used, and the ΔF.F before and after the heat cycle test was measured. The results are shown in Table 2.

Details of the materials shown in Table 1 are as follows. The unit of blending ratio of the components in Table 1 is part by mass. YDF-170: bisphenol F type epoxy resin, product name manufactured by Tohto Kasei Co., Ltd.
TETRAD-X: amine type epoxy resin, product name manufactured by MITSUBISHI GAS CHEMICAL COMPANY, INC.
EP-828: Epikote 828, product name manufactured by Japan epoxy resins Co., Ltd.
2P4MZ: 2-phenyl-4-methylimidazole, product name manufactured by SHIKOKU CHEMICALS CORPORATION
BHPA: 2,2-bis(hydroxymethyl)propionic acid
2,5-DEAD: 2,5-diethyladipic acid
Sn42-Bi58: Sn42-Bi58 solder particles, average particle diameter 20 µm, melting temperature 138°C
Sn40-Bi56-Zn4: Sn40-Bi56-Zn4 solder particles, average particle diameter 20 µm, melting temperature 130°C
MA05K: Ag plated Cu powder, product name manufactured by Hitachi Chemical Co., Ltd., melting temperature 1083°C

### (Comparative Example 1)

A tab wire coated with Sn-Ag-Cu solder (manufactured by Hitachi Cable, Ltd., product name: A-TPS, a product of width 2.0 mm, melting temperature 220°C) was arranged on a busbar (material: silver glass paste, 2 mm × 125 mm) formed on a light receiving surface of a solar cell (125 mm × 125 mm, thickness 310 µm) as a wiring member, and bonded by thermocompression by using a thermocompression bonding machine under conditions of a temperature of 260°C, a load of 0.5 MPa, and a holding time of 10 seconds. The same treatment was performed on electrodes on the rear surface, and thus, 10 sets of the solar cells with tab wire were produced.

For the solar cell with tab wire, evaluation of cell damage rate and confirmation of connecting portion were conducted by the same manner as that in Example 1. Moreover, a solar cell module was produced by the same process as that in Example 1 except that the solar cell with tab wire obtained above was used, and the ΔF.F before and after the heat cycle test was measured. The results are shown in Table 2.

### (Comparative Example 2)

A tab wire coated with Sn-Ag-Cu solder (manufactured by Hitachi Cable, Ltd., product name: A-TPS, a product of width 0.5 mm) was arranged in a direction perpendicular to front surface finger electrodes (material: silver glass paste, 0.15 mm × 125 mm) formed on a light receiving surface of a solar cell (125 mm × 125 mm, thickness 310 µm) and at the right back position of rear surface electrodes as a wiring member, and bonded by thermocompression by using a thermocompression bonding machine under conditions of a temperature of 260°C, a load of 0.5 MPa, and a holding time of 10 seconds. The same treatment was performed on the electrodes on the rear surface, and thus, 10 sets of the solar cells with tab wire were produced.

For the solar cell with tab wire, evaluation of cell damage rate and confirmation of connecting portion were conducted by the same manner as that in Example 1. Moreover, a solar cell module was produced by the same process as that in Example 1 except that the solar cell with tab wire obtained above was used, and the ΔF.F before and after the heat cycle test was measured. The results are shown in Table 2.

### (Comparative Example 3)

A solar cell with tab wire was produced by the same process as that in Example 1 except that Sn42-Bi58 cream solder (manufactured by TAMURA CORPORATION, TLF-401-11, melting temperature 138°C) was used instead of the conductive adhesive composition, and evaluation of cell damage rate and confirmation of connecting portion were conducted. Moreover, a solar cell module was produced by the same process as that in Example 1 except that the solar cell with tab wire obtained above was used, and the ΔF.F before and after the heat cycle test was measured. The results are shown in Table 2.

### (Comparative Example 4)

A conductive adhesive composition was prepared by using 27.9 parts by weight of YDF-170 serving as a resin and 72.1 parts by weight of a silver powder (TCG-1, manufactured by Tokuriki Chemical Research Co., Ltd., product name) serving as conductive particles based on the total amount of 100 parts by weight of the conductive adhesive composition by the same process as that described in the preparation of conductive adhesive composition. By using this conductive adhesive composition, a solar cell with tab wire was produced by the same process as that in Example 1, and evaluation of cell damage rate and confirmation of connecting portion were conducted. Moreover, a solar cell module was produced by the same process as that in Example 1 except that the solar cell with tab wire obtained above was used, and the ΔF.F before and after the heat cycle test was measured. The results are shown in Table 2.

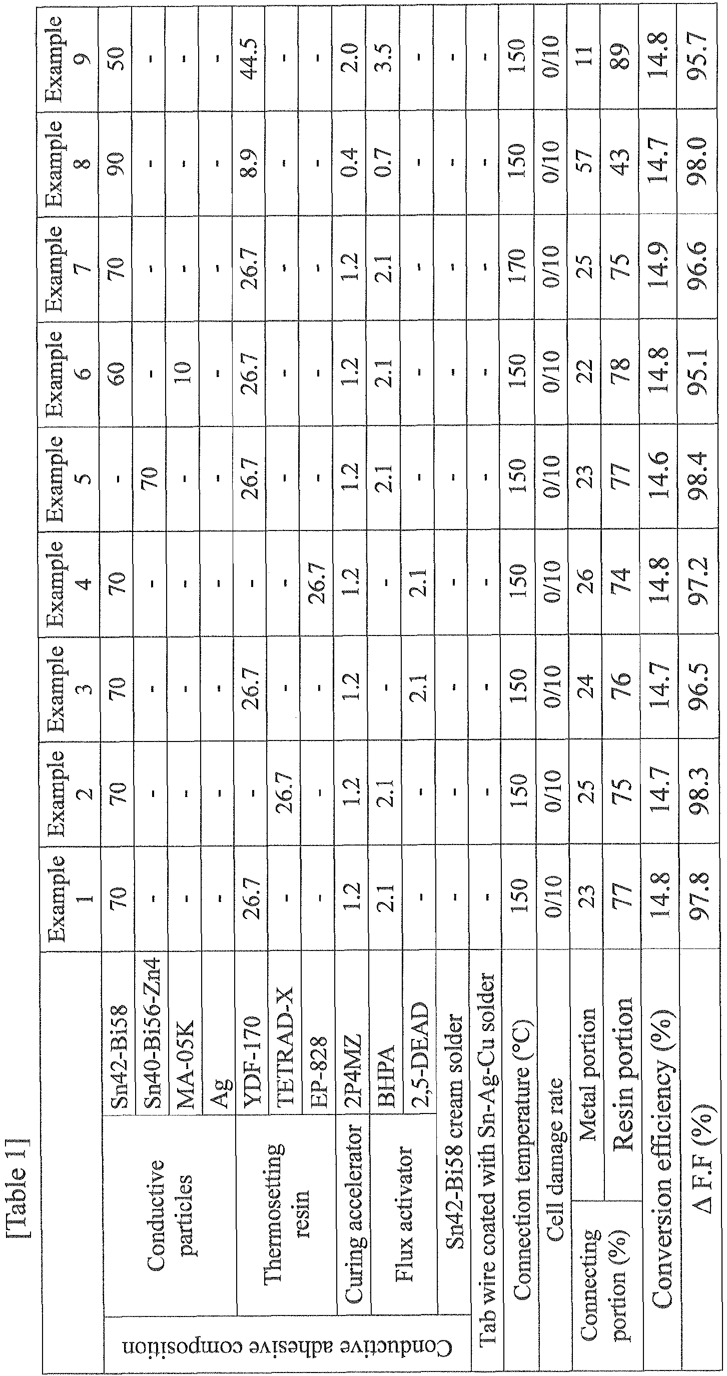

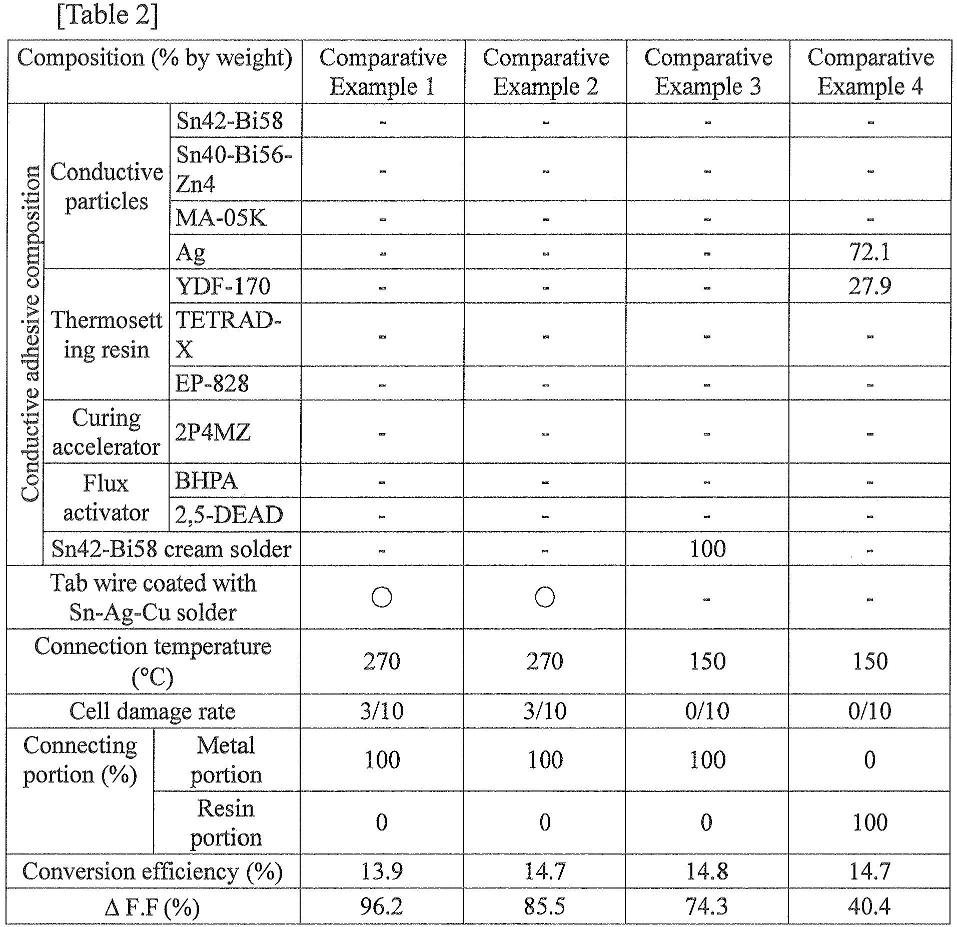

It was confirmed that the solar cell modules of Examples 1 to 9, each comprising a metal portion formed by allowing a metal having a melting temperature of 200°C or less to melt and electrically connecting the finger electrode and the wiring member; and a resin portion bonding the photoelectric conversion body and the wiring member, had no cell damage at the time of connection, had high conversion efficiency, and exhibited sufficiently high ΔF.F before and after the heat cycle test and then had satisfactory reliability.

On the other hand, the solar cells with tab wire of Comparative Examples 1 and 2 in which the wiring members plated with Sn-Ag-Cu solder were used and connection was achieved at 270°C had cell damage and the yields decreased. Moreover, in the configuration of Comparative Example 1 using a busbar, the conversion efficiency decreased. The solar cell module of Comparative Example 3 in which connection was achieved by using the cream solder constituted of Sn42-Bi58 and flux did not have a resin portion and the ΔF.F before and after the heat cycle test decreased. Furthermore, the solar cell module of Comparative Example 4 constituted of the Ag filler and the epoxy resin composition did not have a metal connecting portion and the ΔF.F before and after the heat cycle test decreased.

### Reference Signs List

10: metal portion, 11: resin portion, 16: conductive particles, 17: resin, 18: flux activator, 19: conductive adhesive composition, 100, 200: solar cell module, 101: photoelectric conversion body, 102: wiring member, 103: finger electrode, 104, 107: busbar electrode, 105, 108: connecting portion, 106: rear surface electrode, 107: busbar electrode

## Claims

1. A solar cell module in which a plurality of solar cells and a wiring member for electrically connecting the solar cells are connected via a connecting portion,
wherein a plurality of finger electrodes are formed on a light receiving surface of a photoelectric conversion body of the solar cell,
the wiring member is arranged so as to intersect with the plurality of finger electrodes, and
the connecting portion on a light receiving surface side comprises a metal portion which is formed by allowing conductive particles containing a metal having a melting temperature of 200°C or less to melt and aggregate in a resin and connects the individual finger electrodes and the wiring member; and a resin portion which is composed of the resin and surrounds the metal portion to bond the photoelectric conversion body and the wiring member.

2. The solar cell module according to claim 1, wherein a width of the finger electrodes is 20 to 400 µm.

3. The solar cell module according to claim 1 or 2, wherein the connecting portion on the light receiving surface side is formed by using a conductive adhesive composition comprising (A) conductive particles containing a metal having a melting temperature of 200°C or less, (B) a thermosetting resin, and (C) a flux activator.

4. A solar cell module in which a plurality of solar cells and a wiring member for electrically connecting the solar cells are connected via a connecting portion,
wherein a plurality of finger electrodes are formed on a light receiving surface of a photoelectric conversion body of the solar cell,
the wiring member is arranged so as to intersect with the plurality of finger electrodes,
the connecting portion on a light receiving surface side comprises a metal portion which is formed by allowing conductive particles containing a metal having a melting temperature of 200°C or less to melt and aggregate in a resin and connects the individual finger electrodes and the wiring member; and a resin portion which is composed of the resin filled around the metal portion, and
a cross section of the metal portion has a shape of spreading from the finger electrode side toward the wiring member.
